(19) Europäisches Patentamt European Patent Office Office européen des brevets

(11) **EP 4 131 568 B1**

(12) **EUROPEAN PATENT SPECIFICATION**

(45) Date of publication and mention
of the grant of the patent:
**02.04.2025 Bulletin 2025/14**

(21) Application number: **22739636.3**

(22) Date of filing: **11.01.2022**

(51) International Patent Classification (IPC):
*H01M 10/44* $^{(2006.01)}$    *H01M 10/42* $^{(2006.01)}$
*H01M 10/48* $^{(2006.01)}$    *H02J 7/00* $^{(2006.01)}$
*G01R 19/165* $^{(2006.01)}$    *G01R 31/3835* $^{(2019.01)}$

(52) Cooperative Patent Classification (CPC):
**H02J 7/007182; G01R 19/16542; H01M 10/42;
H01M 10/44; H01M 10/448; H01M 10/48;
H02J 7/0048;** G01R 31/3835; H01M 2010/4271;
Y02E 60/10

(86) International application number:
**PCT/KR2022/000491**

(87) International publication number:
**WO 2022/154441 (21.07.2022 Gazette 2022/29)**

(54) **BATTERY MANAGEMENT APPARATUS AND METHOD**

BATTERIEVERWALTUNGSGERÄT UND -VERFAHREN

APPAREIL ET PROCÉDÉ DE GESTION DE BATTERIE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **12.01.2021 KR 20210004158**

(43) Date of publication of application:
**08.02.2023 Bulletin 2023/06**

(73) Proprietor: **LG Energy Solution, Ltd.
Seoul 07335 (KR)**

(72) Inventors:
• **JEONG, Hee-Seok
Daejeon 34122 (KR)**
• **BAE, Yoon-Jung
Daejeon 34122 (KR)**

(74) Representative: **Plasseraud IP
104 Rue de Richelieu
CS92104
75080 Paris Cedex 02 (FR)**

(56) References cited:
EP-A1- 3 076 478        WO-A1-2012/023215
JP-A- 2001 242 228      KR-A- 20090 060 324
KR-A- 20100 062 201     KR-A- 20180 121 063
KR-A- 20200 111 015

## Description

TECHNICAL FIELD

The present application claims priority to Korean Patent Application No. 10-2021-0004158 filed on January 12, 2021 in the Republic of Korea.

The present disclosure relates to a battery management apparatus and method, and more particularly, to a battery management apparatus and method capable of improving the performance efficiency of a battery.

BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

In addition, recently, in order to achieve various goals such as high capacity and high output of the battery, research on negative electrode active material in which two or more materials are mixed is being conducted. However, since two or more materials have different charge/discharge efficiencies and different reaction voltage ranges from each other, battery degradation issues arise due to rapid degradation of a material with relatively low charge/discharge efficiency. Therefore, for a battery including a negative electrode active material in which two or more kinds of materials are mixed, it is necessary to prepare a way to increase the lifespan.

KR 10-2020-0111015 A discloses a battery management device, which comprises: a voltage measuring unit which measures a voltage when a battery cell is discharged, and measures an open circuit voltage of the battery cell whenever the measured voltage reaches a reference discharge voltage; and a control unit which is configured to receive the open circuit voltage measured by the voltage measuring unit, calculate a voltage fluctuation rate by comparing the received open circuit voltage with a pre-stored reference voltage, determine a voltage increase/decrease pattern based on the calculated voltage fluctuation rate and pre-stored voltage fluctuation rate data, determine a first degree of deterioration acceleration of the battery cell in accordance with the determined voltage increase/decrease pattern, and change a preset control condition based on the received open circuit voltage and the determined first degree of deterioration acceleration.

DISCLOSURE

Technical Problem

The present disclosure is designed to solve the problems of the related art, and therefore the present disclosure is directed to providing a battery management apparatus and method capable of increasing the performance efficiency and lifespan of a battery by adjusting a discharge termination voltage of the battery.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

Technical Solution

A battery management apparatus according to the invention comprises:
a measuring unit configured to measure a voltage of a battery after discharge of the battery is terminated to a preset discharge termination voltage in every cycle; and a control unit configured to receive voltage information of the battery from the measuring unit in every cycle, calculate a first voltage deviation of the battery based on a preset first criterion voltage and the voltage of the battery, calculate a second voltage deviation between the first voltage deviation and a preset second criterion voltage in each cycle, and adjust the discharge termination voltage based on a criterion deviation set to correspond to a current cycle and the second voltage deviation calculated in the current cycle.

The control unit may be configured to determine a cycle region to which the current cycle belongs among a plurality of preset cycle regions, and adjust the discharge termination voltage based on a criterion deviation set for the determined cycle region and the calculated second voltage deviation.

The control unit may be configured to increase the discharge termination voltage, when the calculated second voltage deviation is equal to or greater than the criterion deviation.

The plurality of cycle regions may be set based on a capacity retention rate of each cycle for a reference cell corresponding to the battery.

The control unit may be configured to obtain a capacity profile representing a corresponding relationship between a cycle and a capacity for a reference cell corresponding to the battery, and classify and set a plurality of cycles included in the capacity profile into a plurality of cycle regions according to a capacity change rate for the cycle.

The control unit may be configured to set the criterion deviation for each of the plurality of cycle regions, so that the criterion deviation corresponding to a first cycle region among the plurality of cycle regions is lower than the criterion deviation corresponding to the remaining cycle regions.

After the discharge termination voltage is changed, the control unit may be configured to change the second criterion voltage to the first voltage deviation corresponding to a cycle after the discharge termination voltage is changed.

The measuring unit may be configured to measure a rest voltage of the battery and transmit the rest voltage as the voltage information of the battery, after a predetermined time elapses from the termination of discharge of the battery.

The control unit may be configured to calculate the first voltage deviation by computing a difference between the rest voltage and the first criterion voltage.

A battery pack comprising the battery management apparatus is also provided.

A battery management method according to the invention comprises: a voltage measuring step of measuring a voltage of a battery after discharge of the battery is terminated to a preset discharge termination voltage in every cycle; a first voltage deviation calculating step of calculating a first voltage deviation of the battery based on a preset first criterion voltage and the voltage of the battery; a second voltage deviation calculating step of calculating a second voltage deviation between the first voltage deviation and a preset second criterion voltage in each cycle; and a discharge termination voltage adjusting step of adjusting the discharge termination voltage based on a criterion deviation set to correspond to a current cycle and the second voltage deviation calculated in the current cycle.

## Advantageous Effects

According to one aspect of the present disclosure, the battery management apparatus has an advantage of improving the performance efficiency of the battery and increasing the lifespan of the battery by adjusting the discharge termination voltage based on the voltage of the battery.

The effects of the present disclosure are not limited to the effects mentioned above, and other effects not mentioned will be clearly understood by those skilled in the art from the description of the claims.

## DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.

FIG. 1 is a diagram schematically showing a battery management apparatus according to an embodiment of the present disclosure.
FIG. 2 is a diagram schematically showing a voltage profile of a battery according to an embodiment of the present disclosure and a voltage profile of a reference cell.
FIG. 3 is a diagram schematically showing a capacity profile of the battery according to an embodiment of the present disclosure and a capacity profile of the reference cell.
FIG. 4 is a diagram schematically showing a CE profile of the battery according to an embodiment of the present disclosure and a CE profile of the reference cell.
FIG. 5 is a diagram schematically showing an exemplary configuration of a battery pack according to another embodiment of the present disclosure.
FIG. 6 is a diagram schematically showing a battery management method according to still another embodiment of the present disclosure.

## BEST MODE

It should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that other equivalents and modifications could be made thereto without departing from the scope of the disclosure. The scope of protection is defined solely by the appended claims.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, preferred embodiments of the present disclosure will be described in detail with reference to the accompanying drawings.

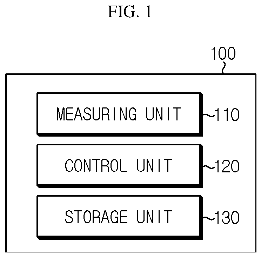

FIG. 1 is a diagram schematically showing a battery management apparatus 100 according to the invention.

Referring to FIG. 1, the battery management apparatus 100 includes a measuring unit 110 and a control unit 120.

The measuring unit 110 is configured to measure the voltage of the battery after the discharge of the battery is terminated to a preset discharge termination voltage in every cycle.

Here, the battery means one physically separable independent cell including a negative electrode terminal and a positive electrode terminal. For example, one pouch-type lithium-ion battery may be regarded as a battery.

Here, the cycle may represent the number of times that the battery is completely discharged after being fully charged. For example, a process in which the battery is charged from 0% to 100% of SOC (State of Charge) and the battery is discharged from 100% to 0% of SOC may be expressed as one cycle.

Specifically, the measuring unit 110 may be configured to measure the rest voltage of the battery after a predetermined time elapses from the termination of discharge of the battery.

For example, the measuring unit 110 may measure the OCV (Open Circuit Voltage) of the battery after a predetermined time elapses from the termination of discharge of the battery.

In addition, the control unit 120 is configured to receive the voltage information of the battery from the measuring unit 110 in every cycle.

For example, the control unit 120 may be connected to communicate with the measuring unit 110. Accordingly, the control unit 120 may receive voltage information of the battery from the measuring unit 110 in every cycle.

Specifically, the measuring unit 110 may be configured to transmit the voltage information of the battery to the control unit 120 in every cycle, so that the rest voltage is transmitted as the voltage information of the battery.

The control unit 120 is configured to calculate a first voltage deviation of the battery based on a preset first criterion voltage and the voltage of the battery.

Specifically, the control unit 120 may calculate the first voltage deviation by computing Formula 1 below.

[Formula 1]

$$VD1 = V - VR1$$

Here, VD1 may be the first voltage deviation, V may be the voltage of the battery measured by the measuring unit 110, and VR1 may be the first criterion voltage.

Specifically, the first criterion voltage is set for a battery in a BOL (Beginning of Life) state, and may be set as an open circuit voltage for the battery in a BOL state. Preferably, the first criterion voltage may be set as an open circuit voltage after the discharge to the battery in a BOL state is terminated. That is, the first voltage deviation VD1 may be calculated according to the difference between the preset first criterion voltage (open circuit voltage) and the measured voltage (open circuit voltage) of the battery.

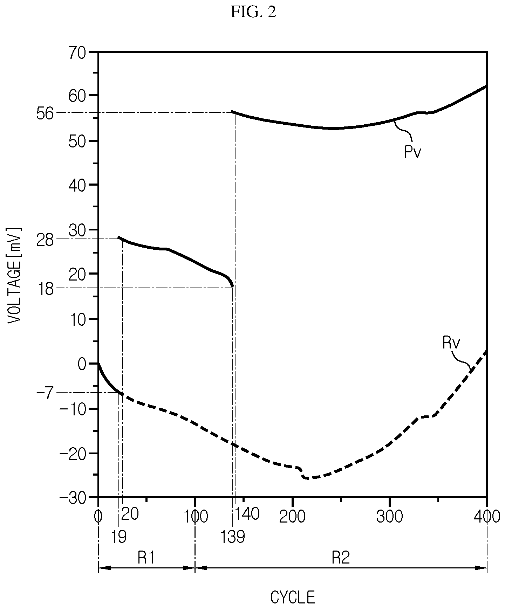

FIG. 2 is a diagram schematically showing a voltage profile Pv of a battery according to an embodiment of the present disclosure and a voltage profile Rv of a reference cell. Specifically, the voltage profile Pv of the battery may be a profile representing a corresponding relationship between the cycle and the voltage of the battery.

For example, in the embodiment of FIG. 2, in the $0^{th}$ cycle, the first voltage deviation VD1 may be preset to 0 mV. In the $19^{th}$ cycle, as a result of the calculation of "the voltage (V) of the battery - the first criterion voltage VR1" according to Formula 1, the first voltage deviation VD1 may be calculated as -7 mV. That is, in the $19^{th}$ cycle, the voltage (V) of the battery may be lower than the first criterion voltage VR1.

The control unit 120 is configured to calculate a second voltage deviation between the first voltage deviation and a preset second criterion voltage in each cycle.

Specifically, the control unit 120 may calculate the second voltage deviation by computing Formula 2 below.

[Formula 2]

$$VD2 = |VD1 - VR2|$$

Here, VD2 may be a second voltage deviation, VD1 may be the first voltage deviation according to Formula 1, and VR2 may be the second criterion voltage. Specifically, the second criterion voltage VR2 may be the first voltage deviation VD1 in the $0^{th}$ cycle or a cycle immediately after the discharge termination voltage is changed.

For example, in the embodiment of FIG. 2, the second criterion voltage VR2 of the $0^{th}$ to $19^{th}$ cycles may be 0 mV. That is, the criterion cycle in the $0^{th}$ to $19^{th}$ cycles may be the $0^{th}$ cycle, and the second criterion voltage VR2 may be 0 mV which is the first voltage deviation VD1 of the $0^{th}$ cycle. That is, in the $0^{th}$ cycle, the first voltage deviation VD1 and the second criterion voltage VR2 may be preset to 0 mV. In the $0^{th}$ to $19^{th}$ cycles, the control unit 120 may calculate the second voltage deviation VD2 by computing the difference between the first voltage deviation VD1 and the second criterion voltage VR2 of the battery according to Formula 2.

Also, in the embodiment of FIG. 2, the second criterion voltage VR2 of the $20^{th}$ cycle to the $139^{th}$ cycle may be 28 mV. That is, the criterion cycle in the 20th cycle to the 139th cycle may be the 20th cycle, and the second criterion voltage VR2 may be 28 mV which is the first voltage deviation VD1 of the 20th cycle. In the 20th to 139th cycles, the control unit 120 may calculate the second voltage deviation VD2 by computing the difference between the first voltage deviation VD1 and the second criterion voltage VR2 of the battery according to Formula 2.

Also, in the embodiment of FIG. 2, the criterion cycle after the 140th cycle may be the 140th cycle, and the second criterion voltage VR2 may be 56 mV, which is the first voltage deviation VD1 of the 140th cycle. After the 140th cycle, the control unit 120 may calculate the second voltage deviation VD2 by computing the difference between the first voltage deviation VD1 and the second criterion voltage VR2 of the battery according to Formula 2.

The control unit 120 is configured to adjust the discharge termination voltage based on a criterion deviation set to correspond to the current cycle and the second voltage deviation calculated in the current cycle.

Specifically, the control unit 120 may be configured to determine a cycle region to which the current cycle belongs among a plurality of preset cycle regions.

For example, in the embodiment of FIG. 2, the plurality of cycle regions may include a first cycle region R1 and a second cycle region R2. The first cycle region R1 may include 0th to 100th cycles, and the second cycle region R2 may include 101st to 400th cycles.

In addition, the control unit 120 may be configured to adjust the discharge termination voltage based on the criterion deviation set for the determined cycle region and the calculated second voltage deviation.

For example, the control unit 120 may be configured to increase the discharge termination voltage, when the calculated second voltage deviation is greater than or equal to the criterion deviation. Conversely, if the calculated second voltage deviation is less than the criterion deviation, the control unit 120 may maintain the discharge termination voltage as it is.

In the embodiment of FIG. 2, the criterion deviation set for the first cycle region R1 may be 7 mV, and the criterion deviation set for the second cycle region R2 may be 10 mV. In addition, the second voltage deviation calculated in the 19th cycle may be 7 mV. That is, in the 19th cycle, since the second voltage deviation (7 mv) between the second criterion voltage (0 mV) and the first voltage deviation (-7 mV) is greater than or equal to the criterion deviation (7 mV) set for the first cycle region R1, the control unit 120 may increase the discharge termination voltage from the 20th cycle.

In addition, the second criterion voltage may be changed from 0 mV to 28 mV from the 20th cycle. That is, after the discharge termination voltage is changed, the control unit 120 may be configured to change the second criterion voltage to the first voltage deviation corresponding to a cycle after the discharge termination voltage is changed.

Also, the second voltage deviation calculated in the 139th cycle may be 10 mV. That is, in the 139th cycle, since the second voltage deviation (10 mV) between the second criterion voltage (28 mV) and the first voltage deviation (18 mV) is greater than or equal to the criterion deviation (10 mV) set for the second cycle region R2, the control unit 120 may further increase the discharge termination voltage from the 140th cycle.

In addition, the second criterion voltage may be changed from 28 mV to 56 mV from the 140th cycle. In the embodiment of FIG. 2, since the second voltage deviation is not calculated as being equal to or greater than the criterion deviation after the 140th cycle, the discharge termination voltage may not be further increased by the control unit 120.

Referring to FIG. 2 further, the voltage profile Rv of the reference cell may be a voltage profile of the reference cell whose discharge termination voltage is not adjusted by the control unit 120. Here, the reference cell corresponds to a battery, and may be a battery prepared for a comparative example that can be compared with the embodiment according to the present disclosure.

Since the discharge termination voltage is not adjusted for the reference cell, the first voltage deviation of the reference cell is decreased till about the 210th cycle, and thereafter, the first voltage deviation may be increased.

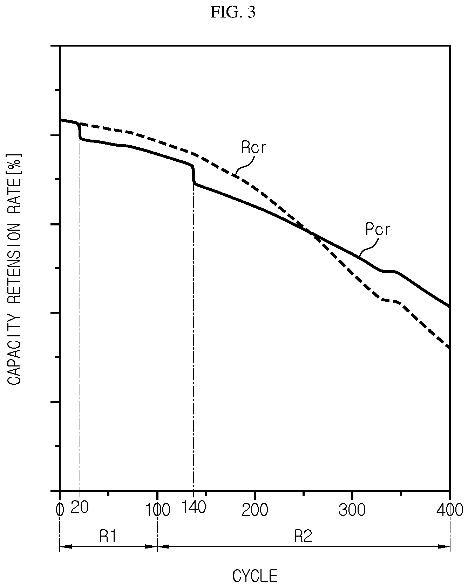

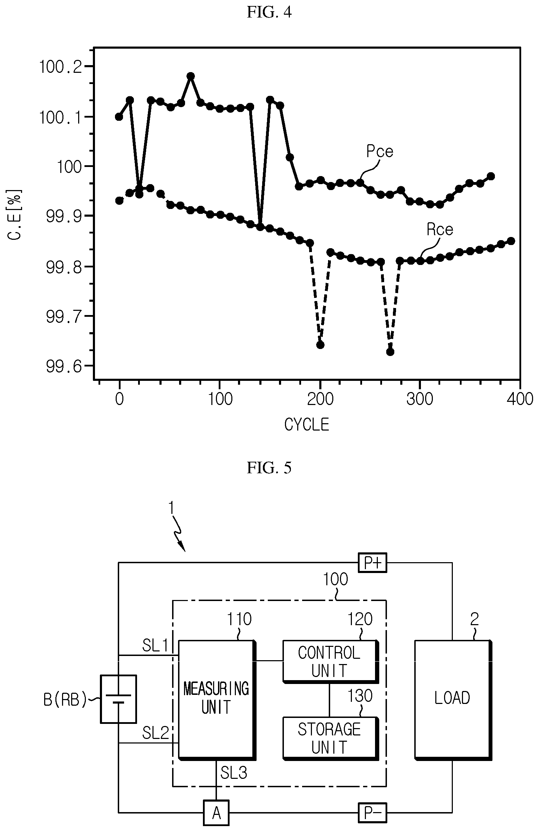

A detailed comparison between the battery and the reference cell will be described with reference to FIGS. 3 and 4.

FIG. 3 is a diagram schematically showing a capacity profile Pcr of the battery according to an embodiment of the present disclosure and a capacity profile Rcr of the reference cell.

Specifically, the capacity profile of FIG. 3 may be a profile representing a corresponding relationship between a cycle and a capacity retention rate. Here, the capacity retention rate may be a ratio of the discharge capacity in the current cycle to the discharge capacity of the battery in the initial cycle.

In general, since battery cells are degraded as the cycle increases, the capacity retention rate may decrease as the cycle increases.

Referring to FIG. 3, from the 0th cycle to the 19th cycle, the capacity retention rate of the battery and the reference cell may be equally reduced. On the other hand, from the 20th cycle in which the discharge termination voltage for the battery is adjusted, the decrease rate of the capacity retention rate of the battery may be lower than the decrease rate of the capacity retention rate of the reference cell. In addition, from the 140th cycle in which the discharge termination voltage for the battery is further adjusted, the decrease rate of the capacity retention rate of the battery may be lower than the decrease rate of the capacity retention rate of the reference cell.

That is, the battery management apparatus 100 according to an embodiment of the present disclosure may lower the decrease rate of the capacity retention rate of the battery by appropriately adjusting the discharge termination voltage for the battery. Therefore, as the battery and the reference cell are degraded, the battery may preserve more capacity compared to the reference cell, so the lifespan of the battery may be increased.

FIG. 4 is a diagram schematically showing a CE profile Pce of the battery according to an embodiment of the present disclosure and a CE profile Rce of the reference cell.

Specifically, the CE profile of FIG. 4 is a profile representing a corresponding relationship between a cycle and a coulombic efficiency (CE). Here, the coulombic efficiency means the ratio of the capacity in the current cycle to the capacity in the previous cycle.

Referring to FIG. 4, the coulombic efficiency of the battery may be maintained within a predetermined level in the $0^{th}$ to about $160^{th}$ cycles. Referring to FIG. 2 further, since the discharge termination voltage is adjusted in the $20^{th}$ cycle and the $140^{th}$ cycle, the coulombic efficiency in the $20^{th}$ cycle and the $140^{th}$ cycle may be temporarily reduced, but the coulombic efficiency may be maintained within a certain level in the other cycles.

In addition, the coulombic efficiency of the battery is maintained within a predetermined level even after about the $160^{th}$ cycle, and may be increased after about the $300^{th}$ cycle.

On the other hand, the coulombic efficiency for the reference cell may decrease as the cycle increases, and may be increased after the $300^{th}$ cycle.

In other words, the coulombic efficiency of the battery whose discharge termination voltage is adjusted by the control unit is maintained within a certain range, but the coulombic efficiency of the reference cell for which the discharge termination voltage is not adjusted at all tends to decrease as the cycle increases (as the reference cell is degraded).

Therefore, the battery management apparatus 100 according to an embodiment of the present disclosure has an advantage of maintaining the coulombic efficiency of the battery at a certain level by adjusting the discharge termination voltage based on the voltage of the battery. Therefore, compared to the reference cell, the performance efficiency of the battery may be improved.

Meanwhile, the control unit 120 provided in the battery management apparatus 100 may selectively include processors known in the art, application-specific integrated circuit (ASIC), other chipsets, logic circuits, registers, communication modems, data processing devices, and the like to execute various control logic performed in the present disclosure. Also, when the control logic is implemented in software, the control unit 120 may be implemented as a set of program modules. At this time, the program module may be stored in a memory and executed by the control unit 120. The memory may be located inside or out of the control unit 120 and may be connected to the control unit 120 by various well-known means.

In addition, the battery management apparatus 100 may further include a storage unit 130. The storage unit 130 may store data necessary for operation and function of each component of the battery management apparatus 100, data generated in the process of performing the operation or function, or the like. The storage unit 130 is not particularly limited in its kind as long as it is a known information storage means that can record, erase, update and read data. As an example, the information storage means may include RAM, flash memory, ROM, EEPROM, registers, and the like. In addition, the storage unit 130 may store program codes in which processes executable by the control unit 120 are defined.

For example, the voltage profile, the capacity profile, and the CE profile for the reference cell may be stored in advance in the storage unit 130.

The plurality of cycle regions may be set based on the capacity retention rate of each cycle for the reference cell corresponding to the battery.

Preferably, the battery and the reference cell may include a negative electrode active material manufactured by mixing two or more materials. Specifically, the battery and the reference cell may include a negative electrode active material in which two or more materials having different charge/discharge efficiencies and reaction voltage ranges are mixed.

For example, in the embodiments of FIGS. 2 to 4, the battery and the reference cell may include a negative electrode active material in which SiO and graphite are mixed. In this case, SiO has lower charge/discharge efficiency and reaction voltage range than graphite, and may express a greater capacity in the initial cycle.

Accordingly, the plurality of cycle regions may be previously classified and set into a cycle region in which a greater capacity is expressed by SiO and a cycle region in which a greater capacity is expressed by graphite.

For example, in the embodiment of FIG. 3, the plurality of cycle regions may be classified and set in advance into a first cycle region R1 including the $0^{th}$ to $100^{th}$ cycles corresponding to SiO and a second cycle region R2 after the $101^{st}$ cycle corresponding to graphite.

Therefore, the battery management apparatus 100 may adjust the discharge termination voltage to correspond to the degradation of the battery by setting a plurality of cycle regions in consideration of the composite negative electrode active material included in the battery and setting a criterion deviation for each cycle region. Therefore, the lifespan of the battery including the composite negative electrode active material may be increased.

Hereinafter, an embodiment in which a plurality of cycle regions are set by the control unit 120 will be described.

The control unit 120 may be configured to obtain a capacity profile representing a corresponding relationship between a cycle and a capacity for the reference cell corresponding to the battery.

For example, in the embodiment of FIG. 3, the control unit 120 may obtain the capacity profile Rcr of the reference cell. The control unit 120 may obtain the capacity profile Rcr of the reference cell from an external server or an external device. Also, the control unit 120 may access the storage unit 130 to obtain the capacity profile Rcr of the reference cell previously stored in the storage unit 130.

The control unit 120 may be configured to classify and set a plurality of cycles included in the capacity profile into a plurality of cycle regions according to the capacity change rate for the cycle.

For example, the capacity change rate may be an instantaneous change rate of the capacity retention rate for a cycle. That is, the control unit 120 may calculate the instantaneous change rate of the capacity retention rate for a cycle as the capacity change rate based on the obtained capacity profile Rcr of the reference cell.

The control unit 120 may be configured to compare the calculated capacity change rate with a criterion change rate and set a plurality of cycle regions according to the comparison result.

For example, the control unit 120 may compare the capacity change rate with the criterion change rate while increasing the cycle by 1 cycle from the $0^{th}$ cycle. In addition, the control unit 120 may determine a cycle in which the capacity change rate is equal to or less than the criterion change rate, and may classify a plurality of cycle regions based on the determined cycles. That is, the control unit 120 may be configured to classify a plurality of cycle regions based on a cycle in which degradation of the reference cell is accelerated.

In the embodiment of FIG. 3, the capacity change rate in the $100^{th}$ cycle may be less than or equal to the criterion change rate. Accordingly, the control unit 120 may set previous cycles as the first cycle region R1 and set subsequent cycles as the second cycle region R2 based on the $100^{th}$ cycle.

Accordingly, the battery management apparatus 100 has an advantage of properly adjusting the discharge termination voltage of the battery by setting a plurality of cycle regions based on the capacity profile Rcr of the reference cell including a composite negative electrode active material in which two or more materials are mixed, and setting a criterion deviation corresponding to each of the plurality of cycles.

The control unit 120 may be configured to set a criterion deviation for each of the plurality of cycle regions, so that a criterion deviation corresponding to the first cycle region among the plurality of cycle regions is set to be lower than a criterion deviation corresponding to the remaining cycle regions.

For example, in the embodiments of FIGS. 2 to 4, the criterion deviation set in the first cycle region R1 may be set smaller than the criterion deviation set in the second cycle region R2.

Specifically, in a battery including two or more types of composite negative electrode active materials, since a capacity is expressed such that the use area of the active material with low charge/discharge efficiency and reaction voltage range is expanded in the initial cycle, the decrease amount of the capacity change rate in the initial cycle may be small.

However, as the capacity of an active material with low charge/discharge efficiency and reaction voltage range is expressed, even though it seems that the total capacity of the battery is preserved, the degradation of the battery may be accelerated.

For example, referring to the capacity profile Rcr of the reference cell of FIG. 3, the change rate of the capacity retention rate in the first cycle region R1 may be lower than the change rate of the capacity retention rate in the second cycle region R2 due to the capacity expression of SiO. However, since the reference cell is degraded due to the capacity expression of SiO, the control unit 120 may set the criterion deviation for the first cycle region R1 to be lower than the criterion deviation for the second cycle region R2. In addition, the control unit 120 may further suppress the capacity expression of SiO included in the battery by adjusting the discharge termination voltage of the battery based on the criterion deviation set differently in the first cycle region R1 and the second cycle region R2. Therefore, since the capacity expression of SiO in the battery may be effectively reduced in the initial cycle, the lifespan of the battery may be increased and the performance efficiency may be improved.

The battery management apparatus 100 according to the present disclosure may be applied to a BMS (Battery Management System). That is, the BMS according to the present disclosure may include the battery management apparatus 100 described above. In this configuration, at least some of the components of the battery management apparatus 100 may be implemented by supplementing or adding functions of the configuration included in the conventional BMS. For example, the measuring unit 110, the control unit 120 and the storage unit 130 may be implemented as components of the BMS.

FIG. 5 is a diagram schematically showing an exemplary configuration of a battery pack 1 according to another embodiment of the present disclosure.

The battery management apparatus 100 according to the present disclosure is provided in a battery pack 1. That is, the battery pack 1 according to the present disclosure includes the above-described battery management apparatus 100 and one or more battery cells B. In addition, the battery pack 1 may further include electrical equipment (relays, fuses, etc.) and a case.

Referring to FIG. 5, a load 2 may be connected to a battery B through a positive electrode terminal P+ and a negative electrode terminal P- of the battery pack 1. The load 2 may be configured to charge and discharge the battery B. Preferably, the load 2 may discharge the battery B to a discharge termination voltage. In addition, the load 2 may discharge the battery B to correspond to the discharge termination voltage changed by the control unit 120.

The measuring unit 110 may be connected to the battery B through a first sensing line SL1 and a second sensing line SL2. The measuring unit 110 may measure the positive electrode voltage of the battery B through the first sensing line SL1 and measure the negative electrode voltage of the battery B through the second sensing line SL2. In addition, the measuring unit 110 may measure the voltage of the battery B by calculating the difference between the measured positive electrode voltage and the measured negative electrode voltage.

If the reference cell RB is included in the battery pack 1, the measuring unit 110 measures the voltage of the reference cell RB, but the discharge termination voltage for the reference cell RB may not be adjusted by the control unit 120.

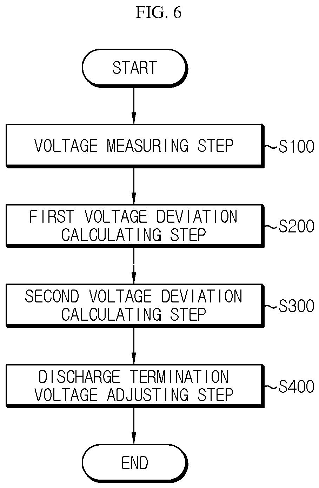

FIG. 6 is a diagram schematically showing a battery management method according to the invention.

Preferably, each step of the battery management method may be performed by the battery management apparatus 100. Hereinafter, it should be noted that contents overlapping with the previously described contents will be omitted or briefly described.

Referring to FIG. 6, the battery management method includes a voltage measuring step (S100), a first voltage deviation calculating step (S200), a second voltage deviation calculating step (S300), and a discharge termination voltage adjusting step (S400).

The voltage measuring step (S100) is a step of measuring the voltage of the battery B after the discharge of the battery B is terminated to a preset discharge termination voltage in every cycle, and may be performed by the measuring unit 110.

The first voltage deviation calculating step (S200) is a step of calculating the first voltage deviation of the battery B based on a preset first criterion voltage and the voltage of the battery B, and may be performed by the control unit 120.

For example, the control unit 120 may calculate the first voltage deviation for the battery B in every cycle based on the measured voltage of the battery B and the preset first criterion voltage.

The second voltage deviation calculating step (S300) is a step of calculating a second voltage deviation between the first voltage deviation and a preset second criterion voltage in each cycle, and may be performed by the control unit 120.

For example, in the $0^{th}$ to $19^{th}$ cycles of the embodiment of FIG. 2, the control unit 120 may calculate the second voltage deviation VD2 by computing the difference between the first voltage deviation VD1 and the second criterion voltage VR2 of the battery according to Formula 2. The second criterion voltage VR2 of the $0^{th}$ to $19^{th}$ cycles may be 0 mV, which is the first voltage deviation VD1 of the $0^{th}$ cycle.

In addition, in the $20^{th}$ to $139^{th}$ cycles of the embodiment of FIG. 2, the control unit 120 may calculate the second voltage deviation VD2 by computing the difference between the first voltage deviation VD1 and the second criterion voltage VR2 of the battery according to Formula 2. The second criterion voltage VR2 of the $20^{th}$ to $139^{th}$ cycles may be 28 mV, which is the first voltage deviation VD1 of the $20^{th}$ cycle.

In addition, the criterion cycle after the $140^{th}$ cycle of the embodiment of FIG. 2 may be the $140^{th}$ cycle, and the second criterion voltage VR2 may be 56 mV, which is the first voltage deviation VD1 of the $140^{th}$ cycle.

The discharge termination voltage adjusting step (S400) is a step of adjusting the discharge termination voltage based on a criterion deviation set to correspond to the current cycle and a second voltage deviation calculated from the current cycle, and may be performed by the control unit 120.

In the embodiment of FIG. 2, the criterion deviation set for the first cycle region R1 may be 7 mV, and the criterion deviation set for the second cycle region R2 may be 10 mV. In addition, the second voltage deviation calculated in the $19^{th}$ cycle may be 7 mV. That is, in the $19^{th}$ cycle, since the second voltage deviation (7 mv) between the second criterion voltage (0 mV) and the first voltage deviation (-7 mV) is greater than or equal to the criterion deviation (7 mV) set for the first cycle region R1, the control unit 120 may increase the discharge termination voltage from the $20^{th}$ cycle.

In addition, the second criterion voltage may be changed from 0 mV to 28 mV from the $20^{th}$ cycle. That is, after the discharge termination voltage is changed, the control unit 120 may be configured to change the second criterion voltage to the first voltage deviation corresponding to a cycle after the discharge termination voltage is changed.

In addition, the second voltage deviation calculated in the $139^{th}$ cycle may be 10 mV. That is, in the $139^{th}$ cycle, since the second voltage deviation (10 mV) between the second criterion voltage (28 mV) and the first voltage deviation (18 mV) is greater than or equal to the criterion deviation (10 mV) set for the second cycle region R2, the control unit 120 may further increase the discharge termination voltage from the $140^{th}$ cycle.

In addition, the second criterion voltage may be changed from 28 mV to 56 mV from the $140^{th}$ cycle. In the embodiment of FIG. 2, since the second voltage deviation is not calculated as being equal to or greater than the criterion deviation after the $140^{th}$ cycle, the discharge termination voltage may not be further increased by the control unit 120.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications. The scope of protection is solely defined by the appended claims.

(Reference Signs)

    1: battery pack
    2: load
    100: battery management apparatus
    110: measuring unit
    120: control unit
    130: storage unit

**Claims**

1. A battery management apparatus (100), comprising:

    a measuring unit (110) configured to measure a voltage of a battery after discharge of the battery is terminated to a preset discharge termination voltage in every cycle; and
    a control unit (120) configured to receive voltage information of the battery from the measuring unit in every cycle, calculate a first voltage deviation of the battery based on a preset first criterion voltage and the voltage of the battery, calculate a second voltage deviation between the first voltage deviation and a preset second criterion voltage in each cycle, and adjust the discharge termination voltage based on a criterion deviation set to correspond to a current cycle and the second voltage deviation calculated in the current cycle.

2. The battery management apparatus (100) according to claim 1,
    wherein the control unit (120) is configured to determine a cycle region to which the current cycle belongs among a plurality of preset cycle regions, and adjust the discharge termination voltage based on a criterion deviation set for the determined cycle region and the calculated second voltage deviation.

3. The battery management apparatus (100) according to claim 2,
    wherein the control unit (120) is configured to increase the discharge termination voltage, when the calculated second voltage deviation is equal to or greater than the criterion deviation.

4. The battery management apparatus (100) according to claim 2,
    wherein the plurality of cycle regions are set based on a capacity retention rate of each cycle for a reference cell corresponding to the battery.

5. The battery management apparatus (100) according to claim 2,
    wherein the control unit (120) is configured to obtain a capacity profile representing a corresponding relationship between a cycle and a capacity for a reference cell corresponding to the battery, and classify and set a plurality of cycles included in the capacity profile into a plurality of cycle regions according to a capacity change rate for the cycle.

6. The battery management apparatus (100) according to claim 5,
    wherein the control unit (120) is configured to set the criterion deviation for each of the plurality of cycle regions, so that the criterion deviation corresponding to a first cycle region among the plurality of cycle regions is lower than the criterion deviation corresponding to the remaining cycle regions.

7. The battery management apparatus (100) according to claim 1,
    wherein after the discharge termination voltage is changed, the control unit (120) is configured to change the second criterion voltage to the first voltage deviation corresponding to a cycle after the discharge termination voltage is changed.

8. The battery management apparatus (100) according to claim 1,

    wherein the measuring unit (110) is configured to measure a rest voltage of the battery and transmit the rest voltage as the voltage information of the battery, after a predetermined time elapses from the termination of discharge of the battery, and
    wherein the control unit (120) is configured to calculate the first voltage deviation by computing a difference between the rest voltage and the first criterion voltage.

9. A battery pack (1), comprising the battery management apparatus (100) according to any one of claims 1 to 8.

10. A battery management method, comprising:

a voltage measuring step (S100) of measuring a voltage of a battery after discharge of the battery is terminated to a preset discharge termination voltage in every cycle;

a first voltage deviation calculating step (S200) of calculating a first voltage deviation of the battery based on a preset first criterion voltage and the voltage of the battery;

a second voltage deviation calculating step (S300) of calculating a second voltage deviation between the first voltage deviation and a preset second criterion voltage in each cycle; and

a discharge termination voltage adjusting step (S400) of adjusting the discharge termination voltage based on a criterion deviation set to correspond to a current cycle and the second voltage deviation calculated in the current cycle.


**Patentansprüche**

1. Batteriemanagementvorrichtung (100), umfassend:

eine Messeinheit (110), welche dazu eingerichtet ist, in jedem Zyklus eine Spannung einer Batterie zu messen, nachdem ein Entladen der Batterie auf eine voreingestellte Entladungsabschlussspannung abgeschlossen ist; und

eine Steuereinheit (120), welche dazu eingerichtet ist, in jedem Zyklus von der Messeinheit Spannungsinformationen der Batterie zu empfangen, auf Grundlage einer voreingestellten ersten Kriterium-Spannung und der Spannung der Batterie eine erste Spannungsabweichung der Batterie zu berechnen, in jedem Zyklus eine zweite Spannungsabweichung zwischen der ersten Spannungsabweichung und einer voreingestellten zweiten Kriterium-Spannung zu berechnen und auf Grundlage einer Kriterium-Abweichung, welche derart eingestellt ist, dass sie einem aktuellen Zyklus entspricht, und der in dem aktuellen Zyklus berechneten zweiten Spannungsabweichung die Entladungsabschlussspannung anzupassen.

2. Batteriemanagementvorrichtung (100) nach Anspruch 1,
wobei die Steuereinheit (120) dazu eingerichtet ist, unter einer Mehrzahl von voreingestellten Zyklusbereichen einen Zyklusbereich zu bestimmen, zu welchem der aktuelle Zyklus gehört, und auf Grundlage einer für den bestimmten Zyklusbereich eingestellten Kriterium-Abweichung und der berechneten zweiten Spannungsabweichung die Entladungsabschlussspannung anzupassen.

3. Batteriemanagementvorrichtung (100) nach Anspruch 2,

wobei die Steuereinheit (120) dazu eingerichtet ist, die Entladungsabschlussspannung zu erhöhen, wenn die berechnete zweite Spannungsabweichung gleich wie oder größer als die Kriterium-Abweichung ist.

4. Batteriemanagementvorrichtung (100) nach Anspruch 2,
wobei die Mehrzahl von Zyklusbereichen für eine Referenzzelle, welche der Batterie entspricht, auf Grundlage einer Kapazitätserhaltungsrate jedes Zyklus eingestellt ist.

5. Batteriemanagementvorrichtung (100) nach Anspruch 2,
wobei die Steuereinheit (120) dazu eingerichtet ist, für eine Referenzzelle, welche der Batterie entspricht, ein Kapazitätsprofil zu erhalten, welches eine entsprechende Beziehung zwischen einem Zyklus und einer Kapazität darstellt, und gemäß einer Kapazitätsänderungsrate für den Zyklus eine Mehrzahl von Zyklen, welche in dem Kapazitätsprofil umfasst sind, in eine Mehrzahl von Zyklusbereiche zu klassifizieren und einzustellen.

6. Batteriemanagementvorrichtung (100) nach Anspruch 5,
wobei die Steuereinheit (120) dazu eingerichtet ist, für jeden der Mehrzahl von Zyklusbereichen die Kriterium-Abweichung derart einzustellen, dass unter der Mehrzahl von Zyklusbereichen die Kriterium-Abweichung, welche einem ersten Zyklusbereich entspricht, geringer ist als die Kriterium-Abweichung, welche den verbleibenden Zyklusbereichen entspricht.

7. Batteriemanagementvorrichtung (100) nach Anspruch 1,
wobei, nachdem die Entladungsabschlussspannung geändert worden ist, die Steuereinheit (120) dazu eingerichtet ist, die zweite Kriterium-Spannung auf die erste Spannungsabweichung zu ändern, welche einem Zyklus entspricht, nachdem die Entladungsabschlussspannung geändert worden ist.

8. Batteriemanagementvorrichtung (100) nach Anspruch 1,

wobei die Messeinheit (110) dazu eingerichtet ist, eine Restspannung der Batterie zu berechnen und die Restspannung als die Spannungsinformationen der Batterie zu übertragen, nachdem eine vorbestimmte Zeit von dem Abschluss eines Entladens der Batterie verstrichen ist, und wobei die Steuereinheit (120) dazu eingerichtet ist, durch ein Berechnen einer Differenz zwischen der Restspannung und der ersten Kriterium-Spannung die erste Spannungsabweichung zu berechnen.

9. Batteriepack (1), umfassend die Batteriemanagementvorrichtung (100) nach einem der Ansprüche 1 bis 8.

10. Batteriemanagementverfahren, umfassend:

einen Spannungsmessschritt (S100) eines Messens einer Spannung einer Batterie, nachdem ein Entladen der Batterie auf eine voreingestellte Entladungsabschlussspannung abgeschlossen ist, in jedem Zyklus;
einen ersten Spannungsabweichungsberechnungsschritt (S200) eines Berechnens einer ersten Spannungsabweichung der Batterie auf Grundlage einer voreingestellten ersten Kriterium-Spannung und der Spannung der Batterie;
einen zweiten Spannungsabweichungsberechnungsschritt (S300) eines Berechnens einer zweiten Spannungsabweichung zwischen der ersten Spannungsabweichung und einer voreingestellten zweiten Kriterium-Spannung in jedem Zyklus; und
einen Entladungsabschlussspannungsanpassungsschritt (S400) eines Anpassens der Entladungsabschlussspannung auf Grundlage einer Kriterium-Abweichung, welche derart eingestellt ist, dass sie einem aktuellen Zyklus entspricht, und der in dem aktuellen Zyklus berechneten zweiten Spannungsabweichung.

**Revendications**

1. Appareil de gestion de batterie (100), comprenant :

une unité de mesure (110) configurée pour mesurer une tension d'une batterie après que la décharge de la batterie prend fin à une tension de fin de décharge prédéfinie à chaque cycle ; et
une unité de commande (120) configurée pour recevoir des informations de tension de la batterie en provenance de l'unité de mesure à chaque cycle, calculer un premier écart de tension de la batterie sur la base d'une première tension étalon prédéfinie et de la tension de la batterie, calculer un second écart de tension entre le premier écart de tension et une seconde tension étalon prédéfinie à chaque cycle, et ajuster la tension de fin de décharge sur la base d'un écart étalon défini pour correspondre à un cycle courant et du second écart de tension calculé dans le cycle courant.

2. Appareil de gestion de batterie (100) selon la revendication 1,
dans lequel l'unité de commande (120) est configurée pour déterminer une région de cycle à laquelle appartient le cycle courant parmi une pluralité de régions de cycle prédéfinies, et ajuster la tension de fin de décharge sur la base d'un écart étalon défini pour la région de cycle déterminée et du second écart de tension calculé.

3. Appareil de gestion de batterie (100) selon la revendication 2,
dans lequel l'unité de commande (120) est configurée pour augmenter la tension de fin de décharge, lorsque le second écart de tension calculé est supérieur ou égal à l'écart étalon.

4. Appareil de gestion de batterie (100) selon la revendication 2,
dans lequel la pluralité de régions de cycle sont définies sur la base d'un taux de maintien de capacité de chaque cycle pour un élément de référence correspondant à la batterie.

5. Appareil de gestion de batterie (100) selon la revendication 2,
dans lequel l'unité de commande (120) est configurée pour obtenir un profil de capacité représentant une relation correspondante entre un cycle et une capacité pour un élément de référence correspondant à la batterie, et classifier et définir une pluralité de cycles inclus dans le profil de capacité en une pluralité de régions de cycle selon un taux de variation de capacité pour le cycle.

6. Appareil de gestion de batterie (100) selon la revendication 5,
dans lequel l'unité de commande (120) est configurée pour définir l'écart étalon pour chacune de la pluralité de régions de cycle, de sorte que l'écart étalon correspondant à une première région de cycle parmi la pluralité de régions de cycle soit inférieur à l'écart étalon correspondant aux régions de cycle restantes.

7. Appareil de gestion de batterie (100) selon la revendication 1,
dans lequel, après que la tension de fin de décharge est modifiée, l'unité de commande (120) est configurée pour modifier la seconde tension étalon par le premier écart de tension correspondant à un cycle après que la tension de fin de décharge est modifiée.

8. Appareil de gestion de batterie (100) selon la revendication 1,

dans lequel l'unité de mesure (110) est configurée pour mesurer une tension de repos de la batterie et transmettre la tension de repos en tant qu'information de tension de la batterie, une fois écoulé un temps prédéterminé à partir de la fin de la décharge de la batterie, et

dans lequel l'unité de commande (120) est configurée pour calculer le premier écart de tension en calculant une différence entre la tension de repos et la première tension étalon.

9. Bloc-batterie (1), comprenant l'appareil de gestion de batterie (100) selon l'une quelconque des revendications 1 à 8.

10. Procédé de gestion de batterie, comprenant :

une étape de mesure de tension (S100) de mesure d'une tension d'une batterie après que la décharge de la batterie prend fin à une tension de fin de décharge prédéfinie à chaque cycle ;

une première étape de calcul d'écart de tension (S200) de calcul d'un premier écart de tension de la batterie sur la base d'une première tension étalon prédéfinie et de la tension de la batterie ;

une seconde étape de calcul d'écart de tension (S300) de calcul d'un second écart de tension entre le premier écart de tension et une seconde tension étalon prédéfinie à chaque cycle ; et

une étape d'ajustement de tension de fin de décharge (S400) d'ajustement de la tension de fin de décharge sur la base d'un écart étalon défini pour correspondre à un cycle courant et du second écart de tension calculé dans le cycle courant.

FIG. 1

FIG. 2

FIG. 3

FIG. 4

FIG. 5

FIG. 6

```
        ┌─────────────────┐
        │      START      │
        └────────┬────────┘
                 │
                 ▼
   ┌──────────────────────────────┐
   │  VOLTAGE MEASURING STEP       │──S100
   └──────────────┬───────────────┘
                  │
                  ▼
   ┌──────────────────────────────┐
   │  FIRST VOLTAGE DEVIATION      │──S200
   │     CALCULATING STEP          │
   └──────────────┬───────────────┘
                  │
                  ▼
   ┌──────────────────────────────┐
   │  SECOND VOLTAGE DEVIATION     │──S300
   │     CALCULATING STEP          │
   └──────────────┬───────────────┘
                  │
                  ▼
   ┌──────────────────────────────┐
   │  DISCHARGE TERMINATION        │──S400
   │  VOLTAGE ADJUSTING STEP       │
   └──────────────┬───────────────┘
                  │
                  ▼
        ┌─────────────────┐
        │      END        │
        └─────────────────┘
```

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020210004158

- KR 1020200111015 A